# EUROPEAN PATENT SPECIFICATION

(11) **EP 1 211 716 B1**
(45) Date of publication and mention of the grant of the patent: **13.02.2008**
(21) Application number: 01127063.4
(22) Date of filing: 14.11.2001
(51) Int. Cl.: H01L 21/28, H01L 21/336

(54) **Fabrication process for semiconductor device using a dummy gate**
Herstellungsverfahren für ein Halbleiterbauelement unter Benutzung eines Dummy-Gates
Procédé de fabrication de dispositif semiconducteur utilisant une grille factice

(30) Priority: 04.12.2000 JP 2000368661
(43) Date of publication of application: 05.06.2002
(73) Proprietor: Sharp Kabushiki Kaisha, Osaka 545-8522 (JP)
(72) Inventor: Tokushige, Nobuaki, Nara-shi, Nara 630-8223 (JP); Kaneko, Seiji, Nara-shi, Nara 631-0804 (JP)
(74) Representative: Müller - Hoffmann & Partner

(56) References cited:
- EP-A- 0 865 076
- US-A- 5 960 270
- US-A- 6 072 221
- US-A- 6 093 967
- PATENT ABSTRACTS OF JAPAN vol. 1999, no. 08, 30 June 1999 (1999-06-30) -& JP 11 074508 A (TOSHIBA CORP), 16 March 1999 (1999-03-16)

## Description

### BACKGROUND OF THE INVENTION

### 1. Field of the Invention

The present invention relates to a fabrication process for a semiconductor device. More specifically, the invention relates to a semiconductor device fabrication method in consideration of prevention of deterioration of a gate insulating film in a semiconductor process and to fabrication process therefor.

### 2. Description of the Related Art

In MOS transistors employing a silicon oxide film as a gate insulating film, the reliability of the gate insulating film is important for improvement of the performance of the transistors.

Where the gate insulating film has a smaller thickness on the order of 4 nm, however, the gate insulating film is liable to be damaged by plasma during impurity doping and processing of a gate electrode and by ions during ion implantation into a channel region and source/drain regions, resulting in deterioration of the reliability of the gate insulating film (e.g., deterioration of TDDB, increase in leak current and reduction in withstand voltage).

One approach to this problem is to employ a dummy gate pattern for formation of a gate electrode as proposed in Japanese Unexamined Patent Publication No. 11-74508 (1999).

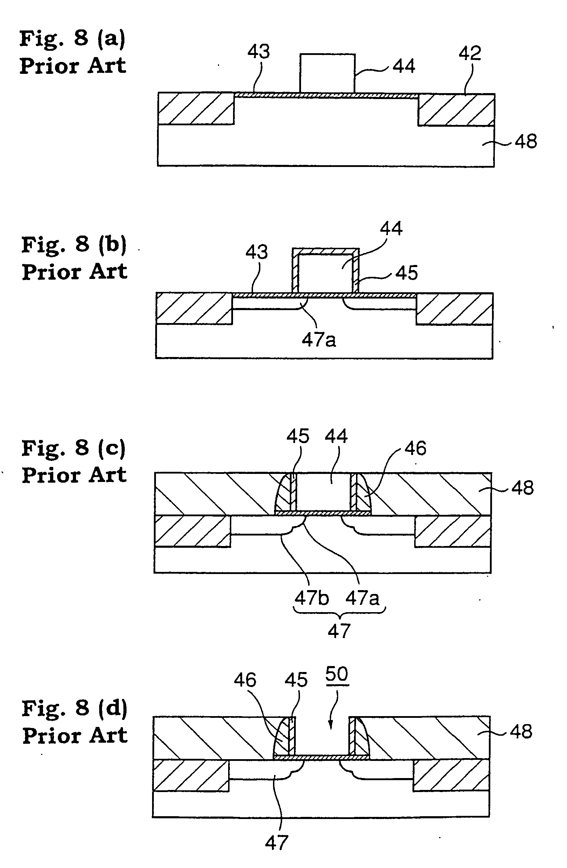

This method will be explained with reference to Figs. 8(a) to 8(h).

First, trenches are formed in a silicon substrate 41, for example, by a reactive ion etching (RIE) process, and insulating films are embedded in the trenches for formation of so-called trench device isolation layers 42 (STI : shallow trench isolation layers having a trench depth of about 0.2 µm). Then, a pad oxide film (dummy insulating film) 43 of SiO₂ having a thickness of about 5 nm is formed on the substrate by thermal oxidation, and an amorphous silicon layer for dummy gate pattern formation is deposited to a thickness of about 300 nm on the pad oxide film 43. The amorphous silicon layer is etched by an RIE process or the like with the use of a resist mask formed by an ordinary lithography process. Thus, a dummy gate pattern 44 is formed which will later be removed for formation of a gate electrode (Fig. 8(a)).

Then, the surface of the dummy gate pattern 44 is thermally oxidized, for example, in an oxygen atmosphere at 850° C, whereby an oxide film 45 having a thickness of about 10 nm is formed as shown in Fig. 8(b). Where an n-channel transistor is to be fabricated, for example, phosphorus (P⁺) ions are implanted into the substrate at 70 keV at a dose of about 4 × 10¹³ cm⁻² by using the dummy gate pattern 44 and the thermal oxide film 45 as a mask, whereby n⁻-type diffusion regions 47a are formed in the substrate for formation of an LDD (lightly doped drain) structure.

In turn, as shown in Fig. 8(c), an Si₃N₄ layer (or an SiO₂ layer) is deposited over the resulting silicon substrate 41, and etched back by an RIE process, whereby a sidewall insulating film 46 having a thickness of about 20 nm is formed on the oxide film 45 on a side wall of the dummy gate pattern 44. By using the dummy gate pattern 44 and the sidewall insulating film 46 as a mask, arsenic (As⁺) ions, for example, are implanted into the substrate at 30 keV at a dose of about 5 × 10¹⁵ cm⁻² for formation of n⁺-type diffusion regions 47b. Thereafter, an interlayer insulating film 48 of SiO₂ is formed over the resulting silicon substrate 41, and the surface thereof is planarized by a CMP (chemical mechanical polishing) process to expose the surface of the dummy gate pattern 44.

Then, as shown in Fig. 8(d), the dummy gate pattern 44 is selectively removed by a CDE (chemical dry etching) process, a wet etching process employing a KOH solution or the like for formation of a trench 50. Thereafter, a channel region is subjected to channel ion implantation, as desired, by using a resist pattern (not shown) formed in a desired region on the substrate, the interlayer insulating film 48, the sidewall insulating film 46 and the oxide film 45 as a mask. Where an n-channel transistor with a threshold voltage (Vth) of about 0.7 V is to be fabricated, boron (B⁺) ions are implanted into a channel region at 10 keV at a dose of about 5 × 10¹² cm⁻², whereby a p-type channel impurity region (not shown) is selectively formed in the channel region.

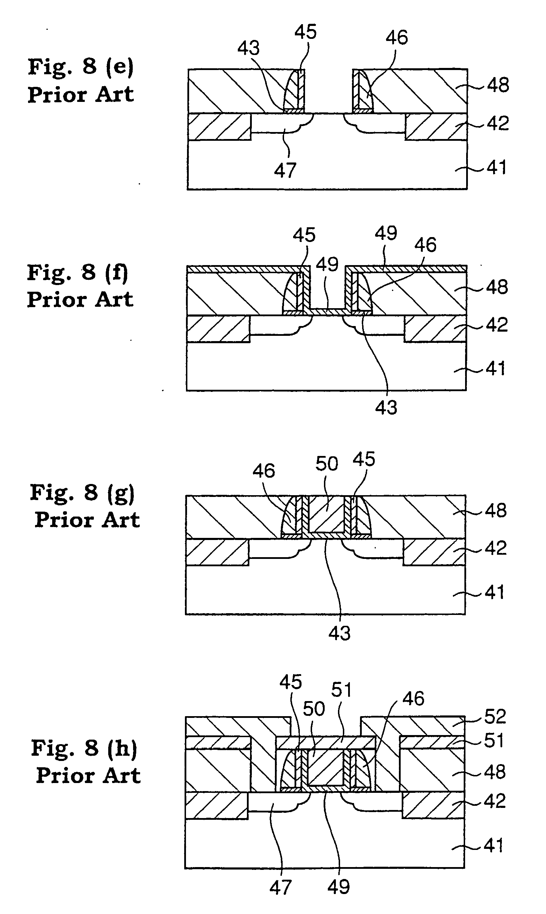

Subsequently, a portion of the pad oxide film 43 on the bottom of the trench 50 is removed as shown in Fig. 8(e).

Further, a gate insulating film 49 is formed over the resulting substrate by depositing a CVD-SiO₂ layer (about 3-nm thick) or a high-dielectric-constant film such as of Ta₂O₅ (about 20-nm thick) as shown in Fig. 8(f).

In turn, a metal film (e.g., a single layer film such as a Ru film, a TiN film, a W film or a tungsten nitride (WNₓ) film, or a laminate film such as constituted by a W film and a TiN film) is formed over the resulting substrate. Then, portions of the metal film and the gate insulating film 49 on the interlayer insulating film 48 are removed by a CMP process, whereby a gate electrode 50 is formed in the trench 50 as shown in Fig. 8(g).

Subsequently, an SiO₂ layer is deposited to a thickness of about 200 nm over the resulting silicon substrate 41 for formation of an interlayer insulating film 51, and contact holes are formed in the interlayer insulating films as extending to the source/drain regions 47 and the gate electrode 50. Then, an Al layer is deposited over the resulting substrate to fill the contact holes, and patterned for formation of an interconnection 52 as shown in Fig. 8(h).

Thereafter, a passivation film (not shown) is formed over the resulting substrate. Thus, the basic structure of the transistor is fabricated.

When the source/drain regions 47 of the transistor thus fabricated are connected to the interconnection 52 through the contact holes, however, a short between the gate electrode 50 and the interconnection 52 is liable to occur due to an alignment shift of the contact holes toward the gate electrode 50 because the contact holes are generally formed by a photolithography process. In other words, alignment processes for the formation of the dummy gate pattern and for the formation of the contact holes are separately performed, and even a slight alignment shift causes the short because distances between the gate electrode and the contact holes are reduced due to micro-miniaturization of the semiconductor device. As a result, the transistor is deteriorated in characteristics and, at the worst, unable to properly operate.

The document US 60 722 221 shows a method of fabricating a MOSFET using a dummy gate and dummy contact plugs. Different materials are used for the respective dummy structures.

### SUMMARY OF THE INVENTION

In accordance with the present invention, there is provided a semiconductor device fabrication process according to claim 1.

Further, there is provided a semiconductor device fabrication process according to claim 6.

### BRIEF DESCRIPTION OF THE DRAWINGS

Figs. 1(a) to 1(j) are schematic sectional views for explaining the semiconductor device fabrication process according to the first embodiment;
Figs. 2(a) to 2(d) are schematic sectional views for explaining a semiconductor device fabrication process according to a second embodiment of the present invention;
Figs. 3(a) to 3(f) are schematic sectional views for explaining a semiconductor device fabrication process according to a third embodiment of the present invention;
Figs. 4(a) to 4(h) are schematic sectional views for explaining the semiconductor device fabrication process according to the fourth embodiment;
Figs. 5(a) to 5(e) are schematic sectional views for explaining a semiconductor device fabrication process according to a fifth embodiment of the present invention;
Figs. 6(a) to 6(e) are schematic sectional views for explaining a semiconductor device fabrication process according to a sixth embodiment of the present invention;
Figs. 7(a) to 7(i) are schematic sectional views for explaining the semiconductor device fabrication process according to the seventh embodiment;
Figs. 8(a) to 8(h) are schematic sectional views for explaining the semiconductor device fabrication process according to the prior art.

### DETAILED DESCRIPTION OF THE INVENTION

In Step (a) of the semiconductor device fabrication process according to the present invention, the dummy gate pattern is formed on the semiconductor substrate with the intervention of the gate insulating film. The semiconductor substrate to be employed in the present invention is not particularly limited, but may be any of those typically employed for fabrication of ordinary semiconductor devices. Exemplary materials for the semiconductor substrate include elemental semiconductors such as silicon and germanium, and compound semiconductors such as GaAs, InGaAs and ZnSe. Any of various substrates including an SOI substrate and a multi-layer SOI substrate may be employed. Further, a so-called epitaxial substrate having an epitaxially grown semiconductor surface layer may be employed. Among these substrates, a silicon substrate is particularly preferred. The semiconductor substrate preferably has a device isolation region formed thereon. Further, the semiconductor substrate may be of a single layer structure or a multi-layer structure formed with such devices as a transistor, a capacitor and a resistor, an interlayer insulating film, a circuit constituted by these devices, a semiconductor device, and the like in combination. The device isolation region is formed by providing any of various device isolation films such as a LOCOS film, a trench oxide film and an STI film, among which the STI film is particularly preferred. Further, one or more high concentration impurity regions (wells) of n-type or p-type may be formed in the surface of the semiconductor substrate.

The gate insulating film may be any of those capable of functioning as a gate insulating film in an ordinary transistor, and examples thereof include insulating films such as silicon oxide films (a CVD-SiO₂ film and a thermal oxide film) and a silicon nitride film, high-dielectric-constant films such as of Ta₂O₅, and a laminate film of these films. The thickness of the gate insulating film is not particularly limited. For example, the thickness is about 0.1 nm to about 20 nm for the insulating films, and about 5 nm to about 50 nm for the high-dielectric-constant films. The formation of the gate insulating film is achieved by a thermal oxidation, a CVD method, a sputtering, an evaporation method and an anodic oxidation, which may be employed either alone or in combination.

The term "dummy gate pattern" herein means a pattern preliminarily formed in a gate electrode formation region. The configuration and thickness of the dummy gate pattern are properly determined depending on the function of the gate electrode to be formed and the characteristics and function of a semiconductor device employing this gate electrode. For example, the thickness of the dummy gate pattern is about 200 nm to about 600 nm. Since the dummy gate pattern is to be removed before the formation of the gate electrode, the material for the dummy gate pattern is properly determined depending on conditions to be employed for the removal of the dummy gate pattern. For example, the dummy gate pattern may be a single layer film or a multi-layer film constituted by: a film of a semiconductor such as polysilicon or amorphous silicon; a film of a metal such as aluminum or nickel or an alloy thereof; a film of a high melting point metal such as tantalum or tungsten; an insulating film such as a silicon oxide film (a thermal oxide film, a low temperature oxidized film (LTO film) or a high temperature oxidized film (HTO film)), a silicon nitride film, an SOG film, a PSG film, a BSG film or a BPSG film; and/or a dielectric film such as a PZT film, a PLZT film, a ferroelectric film or an antiferroelectric film. Among these films, the insulating films, particularly the silicon nitride film and the silicon oxide film are preferred. The silicon nitride film is more preferred.

The formation of the dummy gate pattern is achieved by depositing a layer of the dummy gate pattern material over the semiconductor substrate, and patterning the layer into a desired configuration by a known method, for example, by a photolithography and etching process.

In Step (b), the sidewall insulating film is formed on the side walls of the dummy gate pattern. The sidewall insulating film may be a single-layer film or a multi-layer film constituted by any of the aforesaid insulating films. The sidewall insulating film is preferably formed of a material which is different from the dummy gate pattern material and particularly provides a higher selectivity with respect to the dummy gate pattern when a dummy contact pattern is removed in a later step. More specifically, where the dummy gate pattern is a silicon nitride film, the sidewall insulating film is preferably a silicon oxide film. The formation of the sidewall insulating film is achieved by a known method, for example, by forming an insulating film over the resulting semiconductor substrate and etching back the insulating film by an anisotropic etching process such as an RIE.

The sidewall insulating film preferably has a thickness which ensures electrical isolation between the gate electrode and the contact plug to be formed later and allows for formation of an LDD region having a desired function. For example, the sidewall insulating film has a maximum thickness of about 10 nm to about 50 nm on the side wall of the dummy gate pattern.

In Step (c), the film of the same material as the dummy gate pattern material is formed at least in the contact plug formation region on the semiconductor substrate.

The term "contact plug formation region" herein means a region where the contact plug is formed for electrical connection between a source/drain region in the semiconductor substrate and an interconnection to be formed at a higher level than the gate electrode, and typically a region on the source/drain region.

The film of the same material as the dummy gate pattern material is preferably formed by the same process as for the dummy gate pattern. The same material film may have a smaller thickness than the dummy gate pattern, but preferably has a thickness equal to or greater than the thickness of the dummy gate pattern.

The same material film may be formed only in a region around the dummy gate pattern and the sidewall insulating film in an adjoining relation to the sidewall insulating film, formed in a region including the region around the dummy gate pattern and the sidewall insulating film, or formed over the resulting semiconductor substrate to be double as the interlayer insulating film to be formed in Step (d) which will be described later. The same material film is preferably planarized to be flush with the surface of the dummy gate pattern so that the surface of the dummy gate pattern is not completely covered with the same material film but is exposed. The formation of the same material film in any of the aforesaid regions is achieved by depositing a layer of the same material over the resulting semiconductor substrate, then patterning the layer by a photolithography and etching process, and planarizing the surface of the layer by a CMP process.

In Step (d), the interlayer insulating film is formed on the semiconductor substrate at the sides of the same material film. The material for and the thickness of the interlayer insulating film are not particularly limited, as long as electrical isolation between an underlying interconnection and an overlying interconnection can be ensured. For example, the interlayer insulating film may be formed of a material selected from the aforesaid insulating films, and have substantially the same thickness as the dummy gate pattern. The interlayer insulating film is formed over the resulting semiconductor substrate, and the surface thereof is preferably planarized to expose the surfaces of the dummy gate pattern and the same material film provided therearound. Preferably, the interlayer insulating film, the dummy gate pattern, the same material film and the sidewall insulating film are preferably planarized so that the sidewall insulating film has a flat top edge.

Step (d) is not necessarily required to be performed independently of Step (c), but Steps (c) and (d) may be performed as a single step. In this case, a material which is usable as a material for the interlayer insulating film and the same as the dummy gate pattern material is deposited over the semiconductor substrate including the contact plug formation region.

In Step (e), the dummy gate pattern and the portion of the same material film located in the contact plug formation region are removed, whereby the trenches are formed in the interlayer insulating film. The removal of the dummy gate pattern and the same material film may be achieved by a wet etching process employing hydrofluoric acid, hot phosphoric acid, nitric acid or sulfuric acid, or a dry etching process such as a sputtering, a reactive ion etching or a plasma etching.

Where the interlayer insulating film and the same material film are integrally formed in the single step, the removal of the dummy gate pattern and the same material film is achieved by the aforesaid wet or dry etching process with the use of a resist mask pattern having an opening on the dummy gate pattern, the sidewall insulating film and the contact plug formation region located around the dummy gate pattern and the sidewall insulating film in an adjoining relation to the sidewall insulating film.

Where the top edge of the sidewall insulating film is not planarized in the preceding step, the planarization of the sidewall insulating film may be carried out after the formation of the trenches.

In Step (f), the trenches are filled with the electrically conductive material for formation of the gate electrode and the contact plug. Usable as the electrically conductive material are metals such as aluminum, ruthenium, copper, gold, silver and nickel and alloys thereof, high melting point metals such as tantalum, tungsten and titanium, alloys thereof and nitrides thereof such as TiN and WNₓ, polysilicon, and silicides and polycides of high melting point metals. The gate electrode and the contact plug may be of a single layer structure or a multi-layer structure, and the formation thereof is achieved by any of various processes such as an evaporation process, a sputtering, a CVD method and an EB method. The thickness of the electrically conductive material is not particularly limited, but is preferably such that the electrically conductive material is completely embedded in the trenches. For example, the thickness is about 100 nm to about 600 nm.

The formation of the gate electrode and the contact plug is achieved by depositing a layer of the electrically conductive material over the semiconductor substrate including the trenches, and planarizing the surface of the layer, for example, by a CMP process to expose the interlayer insulating film.

In Step (a') of the semiconductor device fabrication process according to another present invention, the electrically conductive film of the predetermined configuration is formed on the semiconductor substrate with the intervention of the gate insulating film, and the dummy gate pattern is formed on the electrically conductive film. The formation of the gate insulating film is achieved in substantially the same manner as in Step (a). The electrically conductive materials previously described are usable as a material for the electrically conductive film. Among the aforesaid electrically conductive materials, polysilicon is particularly preferred. The thickness of the electrically conductive film is not particularly limited, but may properly be determined in consideration of the thickness of the gate electrode to be formed. The formation of the dummy gate pattern is achieved in substantially the same manner as in Step (a) by depositing a layer of the dummy gate pattern material on the electrically conductive film, and simultaneously patterning the layer and the electrically conductive film.

In Step (b'), the sidewall insulating film is formed on the side walls of the electrically conductive film and the dummy gate pattern. Step (b') is performed in substantially the same manner as Step (b).

In Step (f'), the electrically conductive material is filled in the trenches. The filling of the electrically conductive material is achieved in the same manner as in Step (f). Thus, the contact plug and the gate electrode of a laminate structure constituted by the electrically conductive material and the electrically conductive film are formed.

In Step (a") of the semiconductor device fabrication process according to the still another embodiment of the present invention, the plurality of dummy gate patterns are formed on the semiconductor substrate with the intervention of the gate insulating film. Step (a") is performed in substantially the same manner as Step (a).

In Step (b"), the sidewall insulating films are formed on the side walls of the dummy gate patterns. Step (b") is performed in the same manner as Step (b).

In Step (c"), the dummy contact pattern is formed in the contact plug formation region between the dummy gate patterns in a self-aligned manner. The term "dummy contact pattern" herein means a pattern to be preliminarily formed in a region where the contact plug is to be formed. The configuration and thickness of the dummy contact pattern is properly determined depending on the function of the contact plug to be formed. Since the dummy contact pattern is to be removed before the formation of the contact plug, a material for the dummy contact pattern is properly selected from the materials to be employed for the dummy gate patterns depending on conditions to be employed for the removal of the dummy contact pattern. Where the dummy contact pattern has the same thickness as the dummy gate patterns, for example, the same material is used. In a comparative example, where a material different from the dummy gate pattern material, more specifically a material less liable to be etched than the dummy gate pattern material, is selected, the dummy contact pattern preferably has a smaller thickness than the dummy gate patterns in consideration of an etch selectivity with respect to the dummy gate patterns. The dummy contact pattern is formed of the same material and preferably has the same thickness as the dummy gate patterns.

For the formation of the dummy contact pattern, the dummy contact pattern material is filled in a recess defined between the dummy gate patterns with the intervention of the sidewall insulating films in a self-aligned manner by depositing a layer of the dummy contact pattern material over the semiconductor substrate and planarizing the layer by a CMP process or the like to expose the surface of the dummy gate patterns.

Step (e") is performed in substantially the same manner as Step (e).

The other semiconductor device fabrication process according to the present invention includes, in combination, Steps (a"'), (b"'), (c"), (e") and (f') selected from the steps of the aforesaid production processes.

In Step (aa) of the semiconductor device fabrication process according to the more still another present invention, the plurality of dummy gate patterns are formed on the semiconductor substrate. The formation of the dummy gate patterns is achieved in substantially the same manner as in Step (a).

In Step (b"), the sidewall insulating films are formed on the side walls of the dummy gate patterns. Step (b") is performed in substantially the same manner as Step (b).

In Step (cc), the electrically conductive material is filled in the recess defined between the dummy gate patterns in the contact plug formation region for the formation of the contact plug. The electrically conductive material and the filling method to be employed in Step (cc) are substantially the same as those in Step (f).

In Step (dd), the dummy gate patterns are removed for the formation of the trenches. Step (dd) is performed in substantially the same manner as Steps (e) and (e").

In Step (ee), the gate insulating films are formed at least on the bottom faces of the trenches. The formation of the gate insulating films is achieved in substantially the same manner as in Step (a). The gate insulating films may be formed not only on the bottom faces of the trenches, but over the substrate including the sidewall insulating films.

In Step (ff), the electrically conductive material is filled in the trenches for the formation of the gate electrode. Step (ff) is performed in substantially the same manner as Step (f).

Where the semiconductor device to be fabricated in accordance with any of the aforesaid fabrication processes is a semiconductor memory device, ion implantation is preferably carried out for formation of a low concentration impurity layer and/or a high concentration impurity layer in the substrate before, after or in a desired one of the steps. For the ion implantation, impurity ions may be implanted into the substrate perpendicularly thereto or at a predetermined oblique angle, depending on a position to be formed with the impurity layer, the concentration of the impurity and the method of the ion implantation. The ion implantation allows for formation of source/drain regions of a single structure, an LDD structure or a DDD structure. As required, ion implantation for threshold control, a heat treatment, a salicide process, formation of an insulating film, tightening of the insulating film, formation of a contact hole and/or formation of an interconnection are preferably performed by known methods for the fabrication of the semiconductor device. For example, the heat treatment is performed in air, an oxygen atmosphere or a nitrogen atmosphere at a temperature of about 600° C to about 900° C for about 1 second to about 5 minutes by an oven annealing or an RTA (rapid thermal anneal) for activation of the impurity, for the tightening of the insulating film or for the planarization.

Semiconductor devices and fabrication processes therefor in accordance with embodiments of the present invention will hereinafter be described with reference to the attached drawings.

### Embodiment 1

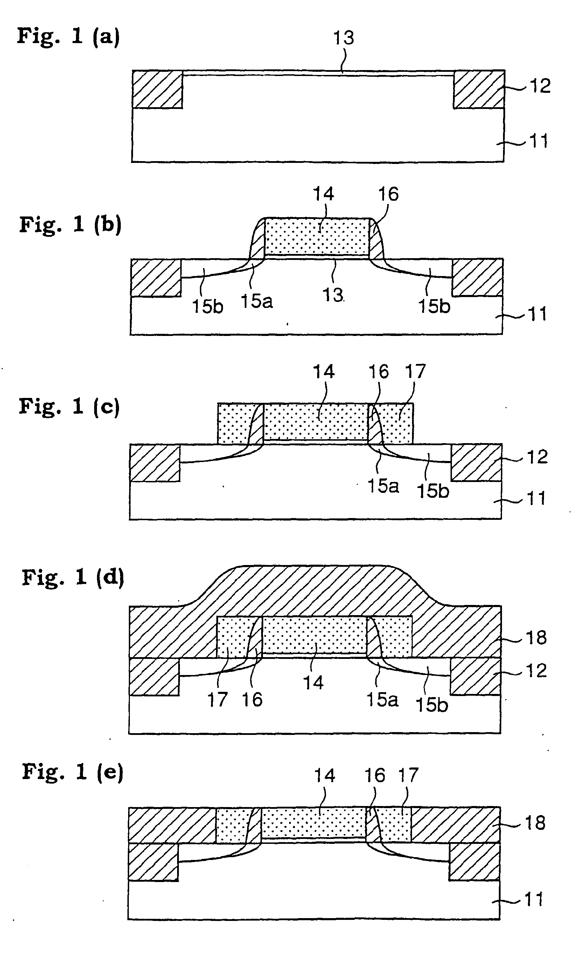

A p-well (not shown) and an n-well (not shown) are formed in an n-channel transistor formation region and a p-channel transistor formation region, respectively, on a silicon (100) surface of a p-type silicon substrate 11 having an impurity concentration of about 5 × 10¹⁵ cm⁻³. Thereafter, trenches are formed in the silicon substrate 11 by an RIE, and insulating films are embedded in the trenches, whereby so-called trench device isolation layers 12 (STI layers having a trench depth of about 0.2 µm) is formed as shown in Fig. 1(a). Then, a CVD-SiO₂ or thermal-SiO₂ film (about 3-nm thick) or a high-dielectric-constant films such as of Ta₂O₅ (about 20-nm thick) is formed over the resulting silicon substrate 11 for formation of a gate insulating film 13.

In turn, a silicon nitride layer for dummy gate pattern formation is deposited to a thickness of about 400 nm on the gate insulating film 13, and etched by an RIE process employing a resist mask pattern (not shown) formed by a lithography process, whereby a dummy gate pattern 14 is formed as shown in Fig. 1(b).

In the case of the n-channel transistor, phosphorus (P⁺) ions, for example, are implanted into the substrate at 70 keV at a dose of about 4 × 10¹³ cm⁻² by using the dummy gate pattern 14 as a mask, whereby n⁻-type diffusion regions 15a are formed in the substrate for formation of an LDD structure.

Subsequently, an SiO₂ layer is deposited over the resulting substrate, and etched back by an RIE, whereby a sidewall insulating film 16 having a thickness of about 20 nm is formed on side walls of the dummy gate pattern 14.

Thereafter, arsenic (As⁺) ions, for example, are implanted into the substrate at 30 keV at a dose of about 5 × 10¹⁵ cm⁻² by using the dummy gate pattern 14 and the sidewall insulating film 16 as a mask for formation of n⁺-type diffusion regions 15b.

After a silicon nitride layer is deposited to a thickness of about 400 nm on the resulting silicon substrate 11 and planarized, the silicon nitride layer is etched by an RIE process employing a resist mask formed by a lithography process, whereby dummy contact patterns 17 to be removed in a later step for contact hole formation are formed around the sidewall insulating film 16 as shown in Fig. 1(c).

In turn, an interlayer insulating film 18 is formed, as shown in Fig. 1(d), by depositing a CVD-SiO₂ layer, for example, to a thickness of about 400 nm over the resulting silicon substrate 11, and heated in an N₂ atmosphere at about 800° C for about 30 minutes for tightening thereof. The heat treatment also serves for activation of the ion implanted regions in source/drain regions.

Thereafter, the surface of the interlayer insulating film 18 is planarized by a CMP process to expose the surface of the dummy gate pattern 14 as shown in Fig. 1(e). At this time, a top edge of the sidewall insulating film 16 may be planarized for prevention of a short between a gate electrode and contacts. In this case, the exposed surfaces of the dummy gate pattern 14 and the dummy contact patterns 17 are etched with hot phosphoric acid or by an RIE process so that the silicon nitride layer is set back. Then, the top edge of the sidewall insulating film 16 is planarized again by the CMP process.

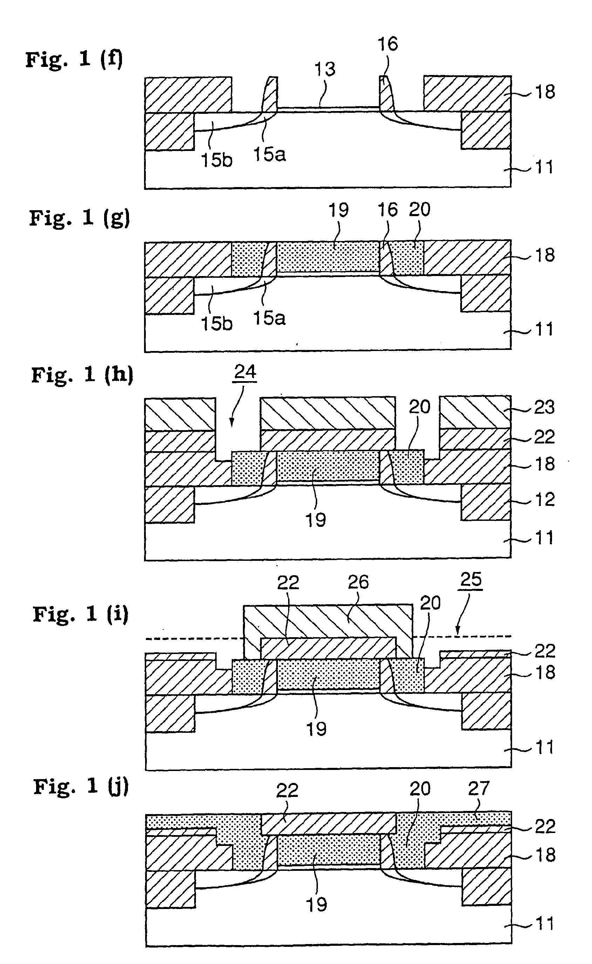

Subsequently, the dummy gate pattern 14 and the dummy contact patterns 17 are selectively removed with the use of hot phosphoric acid or by an RIE process as shown in Fig. 1(f). Then, the resulting substrate is subjected to channel ion implantation. Where the n-channel transistor is allowed to have a threshold voltage (Vₜₕ) of about 0.7 V, for example, boron (B⁺) ions are implanted into the substrate at 10 keV at a dose of about 5 × 10¹² cm⁻² for formation of a p-type channel impurity region (not shown). Thereafter, the resulting substrate is subjected to an RTA, for example, at 800° C for about 10 seconds. Thus, the impurity profile in the channel region can be optimized to suppress a short channel effect of the transistor, because a high-temperature heat treatment is not performed in a later step.

Further, a gate electrode 19 and contact plugs 20 are formed as shown in Fig. 1(g), for example, by depositing an Al layer over the resulting substrate and planarizing the surface thereof. At this time, the side wall insulating film 16 and the interlayer insulating film 18 serve as a stopper of the planarization in the CMP process.

In turn, as shown in Fig. 1(h), an interlayer insulating film 22 is formed by depositing an SiO₂ layer to a thickness of about 300 nm over the resulting silicon substrate 11 by a plasma TEOS process, and etched with the use of a resist mask pattern 23 formed by a lithography process for formation of contact holes 24 for connection to the contact plugs 20 and a contact hole (not shown) for connection to the gate electrode 19.

After the resist pattern 23 is removed, an interconnection is formed by a so-called dual damascene process as shown in Fig. 1(i). That is, a resist pattern 26 having an opening in an interconnection pattern formation region is formed by a lithography process, and trenches 25 having a depth of about 0.25 µm are formed in the interlayer insulating film 22 by an RIE.

After the resist pattern 26 is removed, an Al-Cu film is embedded in the contact holes 24 and the trenches 25 by a high temperature sputtering and reflow process, and planarized by a CMP process, whereby the interconnection 27 is formed as shown in Fig. 1(j).

In this semiconductor device fabrication process, the contact plugs 20 can be formed in the vicinity of the gate electrode 19 in a self-aligned manner, so that electrical isolation between the gate electrode 19 and the contact plugs 20 is ensured for prevention of a short between the gate electrode and the contacts of the interconnection. Further, the contact plugs 20 can be spaced by a minimum distance from the gate electrode 19 as desired by adjusting the thickness of the sidewall insulating film 16. Therefore, the contacts can be provided close to the gate electrode, whereby a parasitic resistance in the source/drain regions can be reduced for improvement of the device characteristics of the transistor.

### Example 1

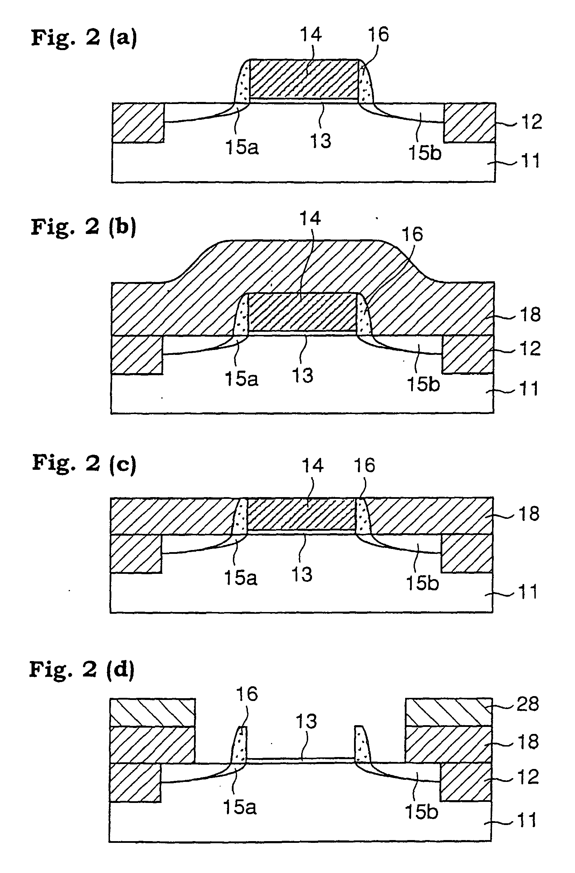

As shown in Fig. 2(a), a gate insulating film 13 of TaO₂ and a dummy gate pattern 14 of CVD-SiO₂ are formed on a silicon substrate 11 having trench device isolation layers 12 in substantially the same manner as in Embodiment 1, followed by formation of n⁻-type diffusion regions 15a, a sidewall insulating film 16 of silicon nitride and n⁺-type diffusion regions 15b.

Then, as shown in Fig. 2(b), an interlayer insulating film 18 of CVD-SiO₂ is formed on the resulting silicon substrate 11, and tightened in substantially the same manner as in Embodiment 1.

Subsequently, the surface of the interlayer insulating film 18 is planarized by a CMP process to expose the surface of the dummy gate pattern 14 as shown in Fig. 2(c).

In turn, the dummy gate pattern 14 and portions of the interlayer insulating film 18 located in contact formation regions around the sidewall insulating film 16 are selectively removed with the use of a resist mask pattern 28 formed by a lithography process as shown in Fig. 2(d).

The subsequent steps are performed in the same manner as in Embodiment 1.

This semiconductor device fabrication process provides the same effects as in Embodiment 1.

### Embodiment 2

A gate insulating film 13 is formed on a silicon substrate 11 having trench device isolation layers 12 as in Embodiment 1.

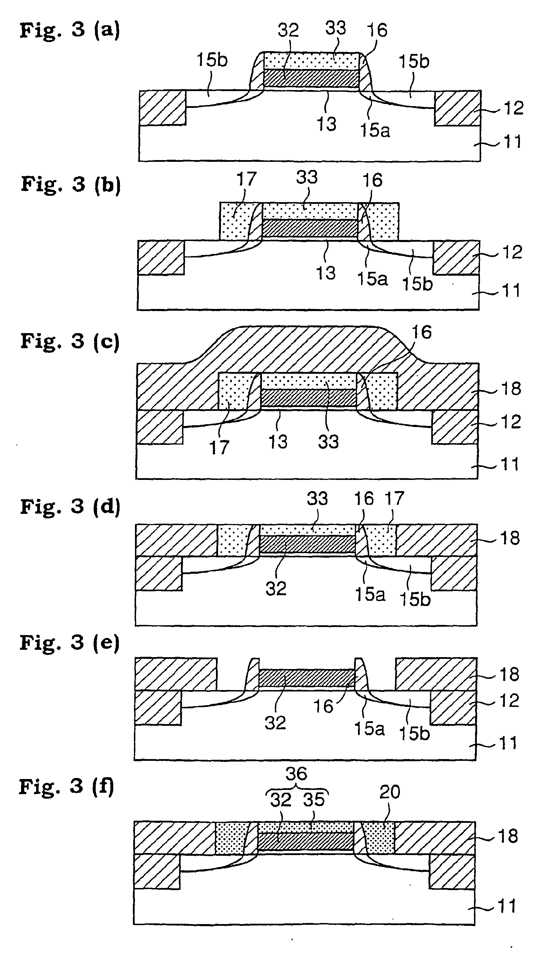

Then, a polysilicon layer 32 serving as a part of a gate electrode is deposited to a thickness of 200 nm on the gate insulating film 13, and doped with an impurity. Further, a silicon nitride layer for dummy gate pattern formation is deposited to a thickness of about 200 nm on the resulting substrate. The polysilicon layer 32 and the silicon nitride layer are etched by an RIE process or the like with the use of a resist mask pattern (not shown) formed by a lithography process, whereby the polysilicon layer 32 is patterned and a dummy gate pattern 33 to be removed for the gate electrode formation in a later step is formed as shown in Fig. 3 (a).

In turn, n⁻-type diffusion regions 15a are formed in the same manner as in Embodiment 1 by using the dummy gate pattern 33 as a mask. Subsequently, a sidewall insulating film 16 is formed in the same manner as in Embodiment 1. Thereafter, n⁺-type diffusion regions 15b are formed in the same manner as in Embodiment 1 by using the dummy gate pattern 33 and the sidewall insulating film 16 as a mask.

Then, dummy contact patterns 17 are formed around the sidewall insulating film 16 in the same manner as in Embodiment 1, as shown in Fig. 3(b).

Subsequently, an interlayer insulating film 18 is formed over the resulting substrate in the same manner as in Embodiment 1, as shown in Fig. 3(c), and the surface thereof is planarized in the same manner as in Embodiment 1 to expose the surface of the dummy gate pattern 33 as shown in Fig. 3(d).

Thereafter, the dummy gate pattern 33 and the dummy contact pattern 17 are selectively removed in the same manner as in Embodiment 1, as shown in Fig. 3(e). At this time, the polysilicon layer 32 underneath the dummy gate pattern 33 is left unremoved.

In turn, a barrier metal film (not shown) such as of Ti, Ta, TaN, W or TiN is formed over the resulting substrate. Then, an Al layer 35, for example, is deposited on the barrier metal film and the surface thereof is planarized in the same manner as in Embodiment 1, whereby a gate electrode 36 constituted by the polysilicon layer 32 and the Al layer 35 and contact plugs 20 constituted by the Al layer 35 are formed as shown in Fig. 3(f).

Thereafter, an interconnection is formed on the resulting substrate in the same manner as in Embodiment 1 by a dual damascene process.

In this semiconductor device fabrication process, the polysilicon layer 32 is present on the gate insulating film 13, thereby preventing over-etching. Thus, the deterioration of the gate insulating film 13 can be prevented.

### Embodiment 3

First, a gate insulating film 13 is formed on a silicon substrate 11 having trench device isolation films 12 in the same manner as in Embodiment 1.

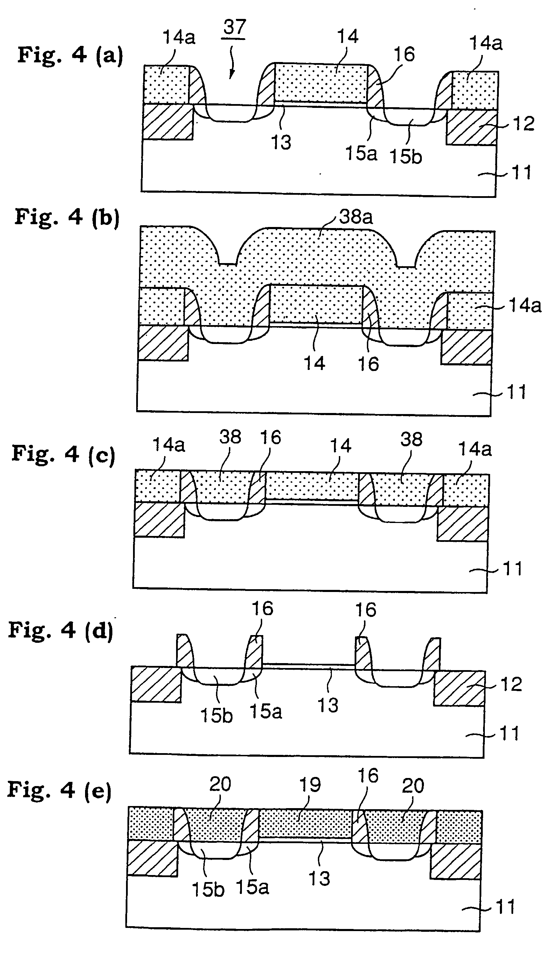

Then, a silicon nitride layer for dummy gate pattern formation is deposited to a thickness of about 300 nm on the gate insulating film 13 and etched by an RIE process employing a resist mask formed by a lithography process, whereby a dummy gate pattern 14 is formed as shown in Fig. 4(a). At the same time, dummy gate patterns 14a are formed on the device isolation layers 12, and trenches 37 are formed in regions where dummy contact patterns are to be formed in a self-aligned manner in a later step.

In turn, n⁻-type diffusion regions 15a are formed in substantially the same manner as in Embodiment 1 by using the dummy gate patterns 14, 14a as a mask. After sidewall insulating films 16 are formed on side walls of the dummy gate patterns 14, 14a in substantially the same manner as in Embodiment 1, n⁺-type diffusion regions 15b are formed in substantially the same manner as in Embodiment 1 by using the dummy gate patterns 14, 14a and the sidewall insulating films 16 as a mask.

Then, a silicon nitride layer 38a is deposited to a thickness of about 400 nm over the silicon substrate 11 including the trenches 37 as shown in Fig. 4(b), and the resulting substrate is subjected to an annealing process, for example, in an N₂ atmosphere at about 750° C for about 60 minutes for recovery from a damage caused due to the implantation for the formation of the source/drain regions. The substrate is further subjected to an RTA in an N₂ atmosphere at about 1000° C for about 10 seconds.

Subsequently, the silicon nitride layer 38a is planarized by a CMP process to expose the surfaces of the dummy gate patterns 14, 14a for formation of dummy contact patterns 38 in the trenches 37 as shown in Fig. 4(c).

In turn, the dummy gate patterns 14, 14a and the dummy contact patterns 38 are selectively removed in the same manner as in Embodiment 1, as shown in Fig. 4(d), and channel ion implantation is carried out in the same manner as in Embodiment 1.

Further, an Al layer, for example, is deposited over the resulting substrate, and the surface thereof is planarized by a CMP process in the same manner as in Embodiment 1, whereby a gate electrode 19 and contact plugs 20 are formed as shown in Fig. 4(e).

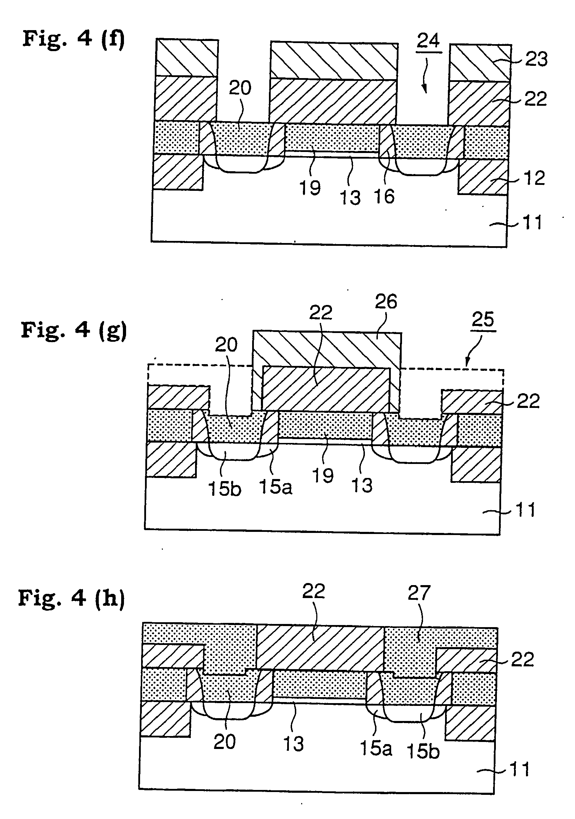

In turn, an interlayer insulating film 22 is formed over the resulting silicon substrate 11, and contact holes 24 and a contact hole (not shown) for connection to the gate electrode 19 are formed in the same manner as in Embodiment 1 with the use of a resist mask pattern 23 as shown in Fig. 4(f).

After the resist pattern 23 is removed, trenches 25 having a depth of about 0.25µm are formed in the interlayer insulating film 22 in the same manner as in Embodiment 1 with the use of a resist pattern 26 as shown in Fig. 4(g). Then, the resist pattern 26 is removed.

Thereafter, an Al-Cu film, for example, is embedded in the contact holes 24 and the trenches 25 and planarized in the same manner as in Embodiment 1, whereby an interconnection 27 is formed as shown in Fig. 4(h).

This semiconductor device fabrication process provides the same effects as in Embodiment 1. In addition, there is no need for the patterning for the formation of the dummy contact patterns 38 around the sidewall insulating films 16 by employing a photolithography process. This simplifies the fabrication process as compared with the fabrication process according to Embodiment 1 by obviating the photolithography process.

### Embodiment 4

First, a gate insulating film 13 is formed on a silicon substrate 11 having trench device isolation layers 12 in the same manner as in Embodiment 1.

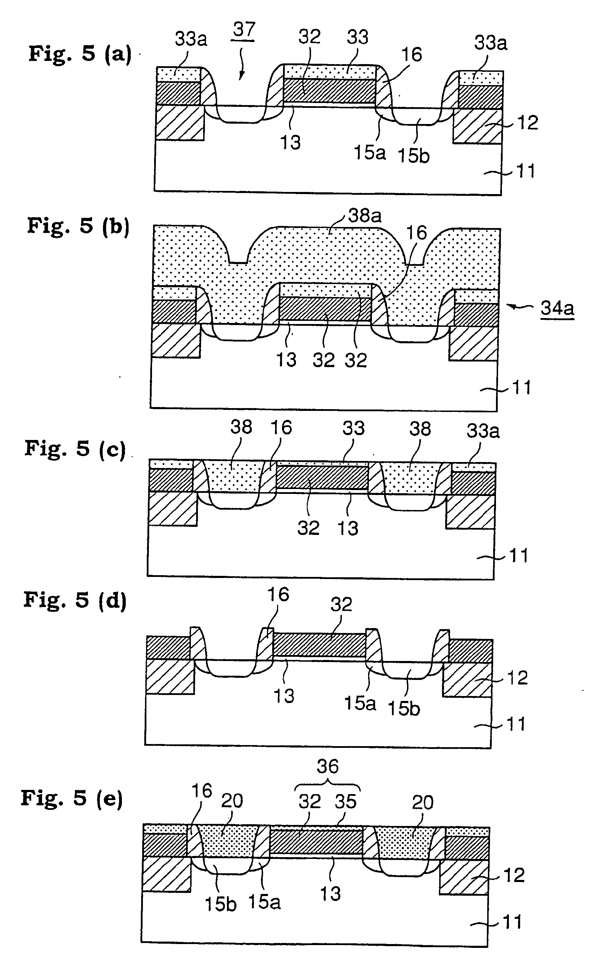

In turn, a polysilicon layer 32 and a silicon nitride layer 33 are deposited to thicknesses of about 20 nm and about 200 nm, respectively, on the resulting substrate and patterned in the same manner as in Embodiment 3, whereby dummy gate patterns 33, 33a are formed as shown in Fig. 5(a). At the same time, trenches 37 are formed in the same manner as in Embodiment 4.

Subsequently, n⁻-type diffusion regions 15a are formed in substantially the same manner as in Embodiment 1 by using the dummy gate patterns 33, 33a as a mask. After sidewall insulating films 16 are formed in substantially the same manner as in Embodiment 1, n⁺-type diffusion regions 15b are formed in substantially the same manner as in Embodiment 1 by using the dummy gate patterns 33, 33a and the sidewall insulating films 16 as a mask.

In turn, a silicon nitride layer 38a is deposited over the silicon substrate 11 including the trenches 37 in the same manner as in Embodiment 4, as shown in Fig. 5(b), and subjected to a heat treatment.

Then, the silicon nitride layer 38a is planarized in the same manner as in Embodiment 4 to expose the surfaces of the dummy gate patterns 33, 33a, whereby dummy contact patterns 38 are formed in the trenches 37 as shown in Fig. 5(c).

Thereafter, the dummy gate patterns 33, 33a and the dummy contact patterns 38 are selectively removed in the same manner as in Embodiment 1, as shown in Fig. 5(d).

Subsequently, an Al layer 35, for example, is deposited over the resulting substrate and planarized in the same manner as in Embodiment 3, whereby a gate electrode 36 constituted by the polysilicon layer 32 and the Al layer 35 and contact plugs 20 each constituted by the Al layer 35 are formed as shown in Fig. 5(e).

Thereafter, an interconnection is formed in the same manner as in Embodiment 1 by a dual damascene process.

This semiconductor device fabrication process provides the same effects as in Embodiment 4. In addition, the polysilicon layer 32 is present on the gate insulating film 13, thereby preventing over-etching. This prevents the deterioration of the gate insulating film 13.

### Example 2

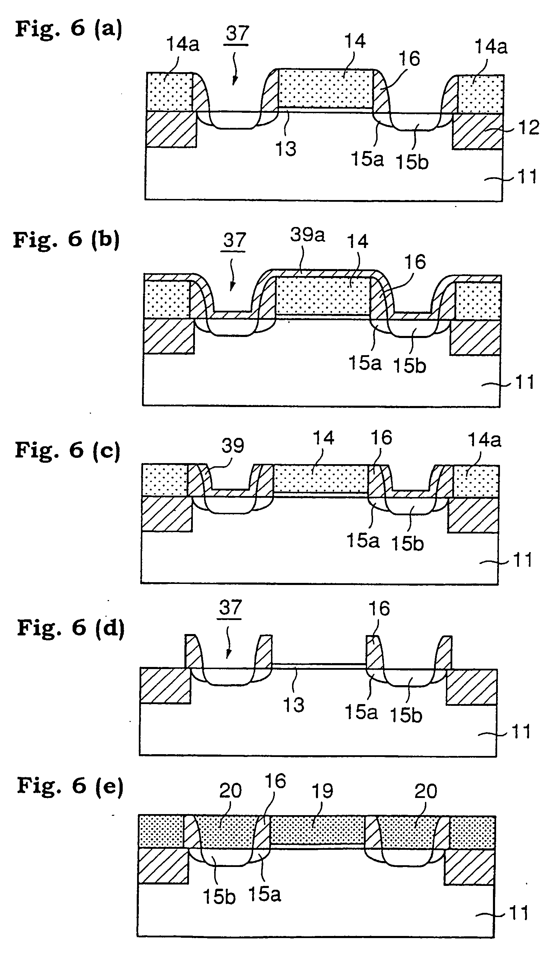

As shown in Fig. 6(a), a silicon substrate 11 having trench device isolation layers 12 is formed with a gate insulating film 13, dummy gate patterns 14, 14a (about 300-nm thick), trenches 37, n⁻-type diffusion regions 15a, n⁺-type diffusion regions 15b and sidewall insulating films 16 in the same manner as in Embodiments 1 and 4.

In turn, a layer of a material different from the material for the dummy gate patterns 14, 14a, e.g., a silicon oxide layer 39, is deposited to a thickness of about 5 nm over the resulting silicon substrate 11 as shown in Fig. 6(b). The thickness of the silicon oxide layer 39 may properly be determined depending on an etching process to be employed for etching the dummy gate patterns 14, 14a in a later step and, in this embodiment, is determined on assumption that an etch selectivity between the silicon nitride layer constituting the dummy gate patterns 14, 14a and the silicon oxide layer 39 is about 60. Then, the resulting substrate is subjected to a heat treatment in the same manner as in Embodiment 1 or 4.

Thereafter, the silicon oxide layer 39 is planarized in substantially the same manner as in Embodiment 1 by a CMP process to expose the surfaces of the dummy gate patterns 14, 14a as shown in Fig. 6(c).

Subsequently, the dummy gate patterns are removed in substantially the same manner as in Embodiment 1, as shown in Fig. 6(d), followed by channel implantation and a heat treatment. At this time, the silicon oxide layer 39 is completely removed from the trenches 37.

In turn, a gate electrode 19 and contact plugs 20 are formed in the same manner as in Embodiments 1 and 4, as shown in Fig. 6(e), and an interconnection is formed in the same manner as in Embodiment 1 by a dual damascene process.

This semiconductor device fabrication process provides the same effects as in Embodiments 4 and 5.

### Example 3

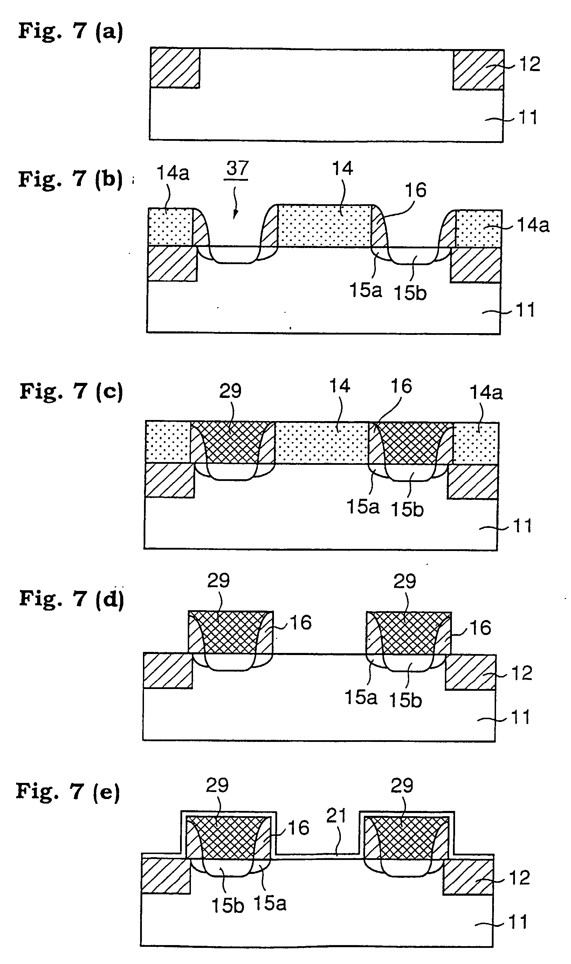

As shown in Fig. 7(a), trench device isolation layers 12 are formed on a silicon substrate 11 in substantially the same manner as in Embodiment 1.

In turn, the resulting silicon substrate 11 is formed with dummy gate patterns 14, 14a, trenches 37, n⁻-type diffusion regions 15a, n⁺-type diffusion regions 15b and sidewall insulating films 16 in the same manner as in Embodiment 4, as shown in Fig. 7(b)

Subsequently, a Cu layer is deposited over the resulting silicon substrate 11 and planarized by a CMP process to expose the surfaces of the dummy gate patterns 14, 14a, whereby contact plugs 29 are formed as shown in Fig. 7(c). Then, the resulting substrate is subjected to a heat treatment in the same manner as in Embodiment 1 or 4.

In turn, the dummy gate patterns 14, 14a are selectively removed in substantially the same manner as in Embodiment 1, as shown in Fig. 7(d), and then channel ion implantation and a heat treatment are performed in the same manner as in Embodiment 1 or 4.

Subsequently, a gate insulating film 21 is formed over the resulting silicon substrate 11 in substantially the same manner as in Embodiment 1, as shown in Fig. 7(e).

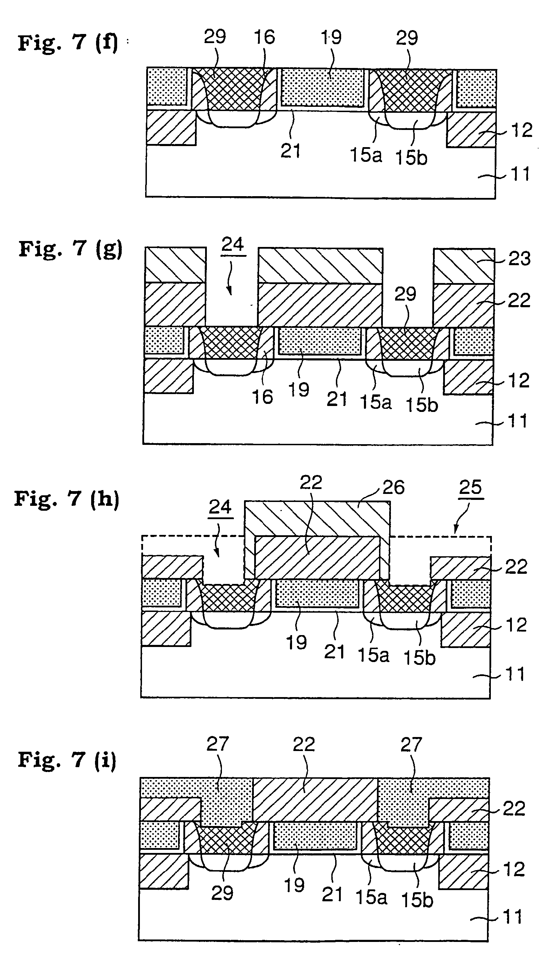

An Al layer, for example, is formed over the resulting substrate and planarized in the same manner as in Embodiment 1, whereby a gate electrode 19 is formed on the gate insulating film 21 as shown in Fig. 7(f).

Further, an interlayer insulating film 22 is formed over the resulting silicon substrate 11, and contact holes 24 for connection to the contact plugs 29 and a contact hole (not shown) for connection to the gate electrode 19 are formed in substantially the same manner as in Embodiment 1 with the use of a resist mask pattern 23 as shown in Fig. 7(g).

After the resist pattern 23 is removed, an interconnection is formed in the same manner as in Embodiment 1 by a dual damascene process. That is, trenches 25 are formed with the use of a resist pattern 26 as shown in Fig. 7(h). After the resist pattern 26 is removed, an Al-Cu film is embedded in the contact holes 24 and the trenches 25 and planarized, whereby the interconnection 27 is formed as shown in Fig. 7(i).

This semiconductor device fabrication process provides the same effects as in Embodiment 1. In addition, the deterioration of the gate insulating film can be prevented because the gate insulating film is formed immediately before the formation of the gate electrode. Thus, the gate insulating film has a higher reliability.

In the semiconductor device fabrication processes according to the present invention, the contact plugs can be formed in self-alignment with the gate electrode, so that a short between the gate electrode and the contact plugs can be prevented which may otherwise occur due to the alignment shift of the contact plugs with respect to the gate electrode. The distances between the gate electrode and the contact plugs are virtually determined by the thickness of the sidewall insulating film. Therefore, the thickness of the sidewall insulating film is reduced for reduction of a device area, thereby increasing the integration degree of the semiconductor device.

Where the electrically conductive film is formed before the formation of the dummy gate pattern, the gate insulating film is not exposed but covered with the electrically conductive film during the process, so that the deterioration of the gate insulating film can be suppressed.

Where the plurality of dummy gate patterns are formed, the dummy contact patterns can be formed between the dummy gate patterns. This obviates a photolithography process for the formation of the dummy contact patterns, thereby simplifying the fabrication process.

Where the formation of the gate insulating film is carried out in a later step of the fabrication process, the deterioration of the gate insulating film can more assuredly be prevented, allowing for fabrication of a highly reliable semiconductor device.

Where the top edge of the sidewall insulating film is planarized before or after the formation of the trenches, contact between the gate electrode and the contact plugs is more assuredly prevented, so that a short between the gate electrode and the contact plugs can be eliminated.

Since a high temperature heat process is performed before the formation of the gate electrode, an electrically conductive material having a lower melting point can be employed as a material for the gate electrode. Therefore, device characteristics can be improved, for example, to achieve a higher speed operation.

Where the dummy gate patterns, or the dummy gate patterns and the dummy contact patterns are each constituted by a silicon nitride film and the sidewall insulating film is constituted by a silicon oxide film, the selective removal of the dummy gate patterns for the formation of the trenches can easily be achieved for easy fabrication of a semiconductor device.

Where the sidewall insulating film and the gate insulating film are located between the gate electrode and the contact plugs, and the top surface of the gate electrode is flush with the top surfaces of the contact plugs, the planarity of the gate electrode and the contact plugs can be ensured. Therefore, a process margin, particularly a photo margin, can be ensured in the subsequent metallization step.

The semiconductor device according to the present invention is free from an inter-device or intra-device short with a minimum device area. Further, the semiconductor device is highly reliable without deterioration of the gate insulating film thereof.

## Claims

1. A semiconductor field effect transistor fabrication process comprising the steps of:
(a) forming a dummy gate pattern (14) on a semiconductor substrate (11) with the intervention of a gate insulting film (13);
(b) forming a sidewall insulting film (16) on opposing side walls of the dummy gate pattern (14);
(c) forming a film (17) of the same material as a material for the dummy gate pattern (14) on the semiconductor substrate at the sides of the sidewall insulating film (16);
(d) forming an interlayer insulating film (18) on the semiconductor substrate at the sides of the same material film (17);
(e) jointly removing the dummy gate pattern (14) and the same material film (17) selective over the sidewall insulating film (16) and the interlayer insulating film (18) to form trenches in the interlayer insulating film (18), the sidewall insulating film (16) being located in the trenches; and
(f) filling the trenches with an electrically conductive material to form a gate electrode (19) and a contact plug (20).

2. A semiconductor device fabrication process according to claim 1, wherein in the steps (a), (b) and (f), the following steps (a'), (b') and (f') are executed, respectively:
(a') forming an electrically conductive film (32) of a predetermined configuration on a semiconductor substrate (11) with the intervention of a gate insulating film (13), and forming a dummy gate pattern (33) on the electrically conductive film (32);
(b') forming a sidewall insulating film (16) on side walls of the electrically conductive film (32) and the dummy gate pattern (33); and
(f') filling the trenches with an electrically conductive material to form a contact plug (20) and a gate electrode (19) which is constituted by the electrically conductive film (32) and the electrically conductive material (35).

3. A process as set forth in claim 1, further comprising the step of planarizing a top edge of the sidewall insulating film (16) before or after the formation of the trenches.

4. A process as set forth in claim 1, wherein the electrically conductive material (35) is a metal or a high melting point metal.

5. A process as set forth in claim 1, wherein the dummy gate pattern (14) comprises a silicon nitride film, and the sidewall insulating film (16) comprises a silicon oxide film.

6. A semiconductor field effect transistor fabrication process comprising the steps of:
(a") forming a dummy gate pattern (14) on a semiconductor substrate (11) with the intervention of a gate insulating film (13) and further dummy gate patterns (14a) of the same material as the dummy gate pattern (14) on device isolation films (12) in the same step;
(b") forming sidewall insulating films (16) on opposing sidewalls of the dummy gate patterns (14, 14a);
(c") forming a dummy contact pattern of the same material as the dummy gate patterns (14, 14a) (38) between the dummy gate pattern (14) and the further dummy gate patterns (14a) on the semiconductor substrate (11) in a self-aligned manner with respect to said sidewall insulting films (16);
(e") Jointly removing the dummy gate patterns and the dummy contact pattern (38) selective to the sidewall insulating films (16) to form trenches between the remaining sidewall insulating films (16); and
(f) filling the trenches with an electrically conductive material (35) to form a gate electrode (19) and a contact plug (20).

7. A semiconductor device fabrication process according to claim 6, wherein in the steps (a"), (b") and (f), the following steps (a"'), (b"') and (f') are executed, respectively:
(a"') forming a plurality of electrically conductive films (32) of a predetermined configuration on a semiconductor substrate (11) with the intervention of a gate insulating film (13), and forming dummy gate patterns (33) on the electrically conductive films (32);
(b"') forming sidewall insulating films (16) on sidewalls of the electrically conductive films (32) and the dummy gate patterns (33); and
(f) filling the trenches with an electrically conductive material (35) to form a contact plug (20) and a gate electrode (19) which is constituted by the electrically conductive films (32) and the electrically conductive material (35).

8. A process as set forth in claim 6, further comprising the step of planarizing a top edge of the sidewall insulating film (16) before or after the formation of the trenches.

9. A process as set forth in claim 6, wherein the electrically conductive material (35) is a metal or a high melting point metal.

10. A process as set forth in claim 6, wherein the dummy gate patterns (14. 14a) each comprise a silicon nitride film, and the sidewall insulating films each comprise a silicon oxide film.

## Patentansprüche

1. Herstellungsverfahren für einen Halbleiter-Feldeffekttransistor mit den Schritten:
(a) Ausbilden eines Dummy-Gatemusters (14) auf einem Halbleitersubstrat (11) mit einem dazwischenliegenden Gateisolationsfilm (13);
(b) Ausbilden eines Seitenwandisolationsfilms (16) an gegenüberliegenden Seitenwänden des Dummy-Gatemusters (14);
(c) Ausbilden eines Films (17) aus demselben Material wie dasjenige des Dummy-Gatemusters (14) auf dem Halbleitersubstrat an den Seitenwänden des Seitenwandisolationsfilms (16);
(d) Ausbilden eines Zwischenschichtisolationsfilms (18) auf dem Halbleitersubstrat an den Seiten des Films aus demselben Material (17);
(e) gemeinsames Entfernen des Dummy-Gatemusters (14) und des Films aus demselben Material (17) selektiv bezüglich des Seitenwandisolationsfilms (16) und des Zwischenschichtisolationsfilms (18) zur Ausbildung von Gräben in dem Zwischenschichtisolationsfilm (18), wobei der Seitenwandisolationsfilm (16) in den Gräben angeordnet ist;
(f) Füllen der Gräben mit einem elektrisch leitfähigen Material zur Ausbildung einer Gateelektrode (19) und eines Kontaktstöpsels (20).

2. Herstellungsverfahren für ein Halbleiterbauelement nach Anspruch 1, wobei in den Schritten (a), (b) und (f) jeweils die folgenden Schritte (a'), (b') und (f') ausgeführt werden:
(a') Ausbilden eines elektrisch leitfähigen Films (32) mit vorgegebenem Aufbau auf einem Halbleitersubstrat (11) mit zwischenliegendem Gateisolationsfilm (13), und Ausbilden eines Dummy-Gatemusters (33) auf dem elektrisch leitfähigen Film (32);
(b') Ausbilden eines Seitenwandisolationsfilms (16) an Seitenwänden des elektrisch leitfähigen Films (32) und des Dummy-Gatemusters (33); und
(f') Füllen der Gräben mit einem elektrisch leitfähigen Material zum Ausbilden eines Kontaktstöpsels (20) und einer Gateelektrode (19), welche aus dem elektrisch leitfähigen Film (32) und dem elektrisch leitfähigen Material (35) besteht.

3. Verfahren nach Anspruch 1, zusätzlich umfassend den Schritt des Planarisierens einer oberen Kante des Seitenwandisolationsfilms (16) vor oder nach dem Ausbilden der Gräben.

4. Verfahren nach Anspruch 1, wobei das elektrisch leitfähige Material (35) ein Metall oder ein Metall mit hohem Schmelzpunkt ist.

5. Verfahren nach Anspruch 1, wobei das Dummy-Gatemuster (14) einen Siliziumnitridfilm umfasst, und der Seitenwandisolationsfilm (16) einen Siliziumoxidfilm umfasst.

6. Herstellungsverfahren für einen Halbleiter-Feldeffekttransistor, umfassend die Schritte:
(a") Ausbilden, im selben Schritt, eines Dummy-Gatemusters (14) auf einem Halbleitersubstrat (11) mit einem dazwischenliegenden Gateisolationsfilm (13) und weiteren Dummy-Gatemustern (14a) auf Vorrichtungsisolationsfilmen (12), wobei die weiteren Dummy-Gatemuster (14a) aus demselben Material wie das Dummy-Gatemuster (14) bestehen;
(b") Ausbilden von Seitenwandisolationsfilmen (16) an gegenüberliegenden Seitenwänden des Dummy-Gatemusters (14, 14a);
(c") Ausbilden eines Dummy-Kontaktmusters (38) in selbstjustierter Weise bezüglich der Seitenwandisolationsfilme (16) und aus demselben Material wie die Dummy-Gatemuster (14, 14a) zwischen dem Dummy-Gatemuster (14) und den weiteren Dummy-Gatemustern (14a) auf dem Halbleitersubstrat (11);
(e") gemeinsames Entfernen der Dummy-Gatemuster und des Dummy-Kontaktmusters (38) selektiv in Bezug auf die Seitenwandisolationsfilme (16) zur Ausbildung von Gräben zwischen den verbleibenden Seitenwandisolationsfilmen (16); und
(f) Füllen der Gräben mit einem elektrisch leitfähigen Material (35) zur Ausbildung einer Gateelektrode (19) und eines Kontaktstöpsels (20).

7. Herstellungsverfahren für ein Halbleiterspeicherbauelement nach Anspruch 6, wobei in den Schritten (a"), (b") und (f) jeweils die folgenden Schritte (a"'), (b"') und (f) ausgeführt werden:
(a"') Ausbilden einer Mehrzahl elektrisch leitfähiger Filme (32) mit einem bestimmten Aufbau auf einem Halbleitersubstrat (11) mit einem dazwischen eingefügten Gateisolationsfilm (13), und Ausbilden von Dummy-Gatemustern (33) auf den elektrisch leitfähigen Filmen (32);
(b"') Ausbilden von Seitenwandisolationsfilmen (16) an Seitenwänden der elektrisch leitfähigen Filme (32) und der Dummy-Gatemuster (33); und
(f) Füllen der Gräben mit einem elektrisch leitfähigen Material (35) zum Ausbilden eines Kontaktstöpsels (20) und einer Gateelektrode (19), die aus den elektrisch leitfähigen Filmen (32) und dem elektrisch leitfähigen Material (35) besteht.

8. Verfahren nach Anspruch 6, zusätzlich umfassend den Schritt des Planarisierens einer Oberkante des Seitenwandisolationsfilms (16) vor oder nach dem Ausbilden der Gräben.

9. Verfahren nach Anspruch 6, wobei das elektrisch leitfähige Material (35) ein Metall oder ein Metall mit hohem Schmelzpunkt ist.

10. Verfahren nach Anspruch 6, wobei die Dummy-Gatemuster (14, 14a) jeweils einen Siliziumnitridfilm aufweisen und die Seitenwandisolationsfilme jeweils einen Siliziumoxidfilm aufweisen.

## Revendications

1. Procédé de fabrication d'un transistor à effet de champ à semi-conducteur comprenant les étapes consistant à :
(a) former un motif de grille factice (14) sur un substrat semi-conducteur (11) avec l'intervention d'un film isolant de grille (13) ;
(b) former un film isolant de paroi latérale (16) sur les parois latérales opposées du motif de grille factice (14) ;
(c) former un film (17) du même matériau que le matériau du motif de grille factice (14) sur le substrat semi-conducteur sur les côtés du film isolant de paroi latérale (16) ;
(d) former un film isolant intercalaire (18) sur le substrat semi-conducteur sur les côtés du film du même matériau (17) ;
(e) retirer conjointement le motif de grille factice (14) et le film du même matériau (17) de manière sélective sur le film isolant de paroi latérale (16) et le film isolant intercalaire (18) pour former des tranchées dans le film isolant intercalaire (18), le film isolant de paroi latérale (16) étant situé dans les tranchées ; et
(f) remplir les tranchées avec un matériau électriquement conducteur pour former une électrode de grille (19) et une prise de contact (20).

2. Procédé de fabrication d'un dispositif à semi-conducteur selon la revendication 1, dans lequel dans les étapes (a), (b) et (f), les étapes suivantes (a'), (b') et (f') sont exécutées, respectivement :
(a') former un film électriquement conducteur (32) selon une configuration prédéterminée sur un substrat semi-conducteur (11) avec l'intervention d'un film isolant de grille (13), et former un motif de grille factice (33) sur le film électriquement conducteur (32) ;
(b') former un film isolant de paroi latérale (16) sur les parois latérales du film électriquement conducteur (32) et du motif de grille factice (33) ; et
(f') remplir les tranchées avec un matériau électriquement conducteur pour former une prise de contact (20) et une électrode de grille (19) constituée du film électriquement conducteur (32) et du matériau électriquement conducteur (35).

3. Procédé selon la revendication 1, comprenant également l'étape de planarisation d'un bord supérieur du film isolant de paroi latérale (16) avant ou après la formation des tranchées.

4. Procédé selon la revendication 1, dans lequel le matériau électriquement conducteur (35) est un métal ou un métal à point de fusion élevé.

5. Procédé selon la revendication 1, dans lequel le motif de grille factice (14) comprend un film de nitrure de silicium, et le film isolant de paroi latérale (16) comprend un film d'oxyde de silicium.

6. Procédé de fabrication d'un transistor à effet de champ à semi-conducteur, comprenant les étapes consistant à :
(a") former un motif de grille factice (14) sur un substrat semi-conducteur (11) avec l'intervention d'un film isolant de grille (13) et d'autres motifs de grille factices (14a) du même matériau que le motif de grille factice (14) sur des films isolants du dispositif (12) dans la même étape ;
(b") former des films isolants de paroi latérale (16) sur les parois latérales opposées des motifs de grille factices (14, 14a) ;
(c") former un motif de contact factice (38) du même matériau que les motifs de grille factices (14, 14a) entre le motif de grille factice (14) et les autres motifs de grille factices (14a) sur le substrat semi-conducteur (11) de façon auto-alignée par rapport auxdits films isolants de paroi latérale (16) ;
(e") retirer conjointement les motifs de grille factices et le motif de contact factice (38) de manière sélective sur les films isolants de paroi latérale (16) pour former des tranchées entre les films isolants de paroi latérale (16) restants ; et
(f) remplir les tranchées avec un matériau électriquement conducteur (35) pour former une électrode de grille (19) et une prise de contact (20).

7. Procédé de fabrication d'un dispositif à semi-conducteur selon la revendication 6, dans lequel dans les étapes (a"), (b") et (f), les étapes suivantes (a"'), (b"') et (f') sont exécutées, respectivement :
(a'") former plusieurs films électriquement conducteurs (32) selon une configuration prédéterminée sur un substrat semi-conducteur (11) avec l'intervention d'un film isolant de grille (13), et former des motifs de grille factices (33) sur les films électriquement conducteurs (32) ;
(b'") former des films isolants de paroi latérale (16) sur les parois latérales des films électriquement conducteurs (32) et les motifs de grille factices (33) ; et
(f') remplir les tranchées avec un matériau électriquement conducteur (35) pour former une prise de contact (20) et une électrode de grille (19) constituée des films électriquement conducteurs (32) et du matériau électriquement conducteur (35).

8. Procédé selon la revendication 6, comprenant également l'étape consistant à rendre plat un bord supérieur du film isolant de paroi latérale (16) avant ou après la formation des tranchées.

9. Procédé selon la revendication 6, dans lequel le matériau électriquement conducteur (35) est un métal ou un métal à point de fusion élevé.

10. Procédé selon la revendication 6, dans lequel les motifs de grille factices (14, 14a) comprennent chacun un film de nitrure de silicium, et les films isolants de paroi latérale comprennent chacun un film d'oxyde de silicium.
